(19) Europäisches Patentamt / European Patent Office / Office européen des brevets

(11) **EP 3 134 745 B1**

(12) # EUROPÄISCHE PATENTSCHRIFT

(45) Veröffentlichungstag und Bekanntmachung des Hinweises auf die Patenterteilung:
**08.07.2020 Patentblatt 2020/28**

(21) Anmeldenummer: **15712890.1**

(22) Anmeldetag: **26.03.2015**

(51) Int Cl.:
*G01R 33/36* *(2006.01)*  *H03H 7/42* *(2006.01)*
*H01P 3/06* *(2006.01)*  *H01P 5/02* *(2006.01)*
*H03H 7/38* *(2006.01)*

(86) Internationale Anmeldenummer:
**PCT/EP2015/056538**

(87) Internationale Veröffentlichungsnummer:
**WO 2015/161982 (29.10.2015 Gazette 2015/43)**

(54) **VORRICHTUNG UND VERFAHREN ZUR ELEKTRISCHEN ANBINDUNG VON ELEKTRONISCHEN BAUGRUPPEN MITTELS SYMMETRISCHER ABGESCHIRMTER LEITUNG**

DEVICE AND METHOD FOR ELECTRICALLY LINKING ELECTRONIC ASSEMBLIES BY MEANS OF SCREENED BALANCED LINE

DISPOSITIF ET PROCÉDÉ DE RACCORDEMENT ÉLECTRIQUE DE MODULES ÉLECTRONIQUES AU MOYEN DE LIGNE SYMÉTRIQUE BLINDÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.04.2014 DE 102014105800**

(43) Veröffentlichungstag der Anmeldung:
**01.03.2017 Patentblatt 2017/09**

(73) Patentinhaber: **Max-Planck-Gesellschaft zur Förderung der Wissenschaften 80539 Munich (DE)**

(72) Erfinder:
• **MÜLLER, Roland
  04299 Leipzig (DE)**
• **MÖLLER, Harald E.
  04107 Leipzig (DE)**

(74) Vertreter: **Hannke, Christian
  Hannke Bittner & Partner
  Patent- und Rechtsanwälte mbB
  Prüfeninger Straße 1
  93049 Regensburg (DE)**

(56) Entgegenhaltungen:
EP-A1- 2 567 658        WO-A1-2010/003215
WO-A2-2011/051872      DE-A1- 10 113 661
DE-T2- 69 734 233       DE-T2-602004 007 641
US-A1- 2010 329 527     US-A1- 2011 037 471
US-A1- 2011 243 255

• **R.MÜLLER ET AL.: "A Double-Row Transmit Array with Broadband Sheath-Wave Damping for 7T Human Head Imaging", PROC.INTL.SOC.MAG.RESON.MED. 22, 25. April 2014 (2014-04-25), Seite 1317, XP040662386,**
• **PICARD L ET AL: "IMPROVEMENTS IN ELECTRONIC DECOUPLING OF TRANSMITTER AND RECEIVER COILS", JOURNAL OF MAGNETIC RESONANCE. SERIES B, ACADEMIC PRESS, ORLANDO, FL, US, Bd. 106, Nr. 2, 1. Februar 1995 (1995-02-01), Seiten 110-115, XP000544498, ISSN: 1064-1866, DOI: 10.1006/JMRB.1995.1020 in der Anmeldung erwähnt**
• **Anonymous: "Balanced line - Wikipedia, the free encyclopedia", , 21 February 2014 (2014-02-21), XP055595969, Retrieved from the Internet: URL:https://web.archive.org/web/2014030101 1128/https://en.wikipedia.org/wiki/Balance d_line [retrieved on 2019-06-12]**

## Beschreibung

Die vorliegende Erfindung betrifft eine symmetrische abgeschirmte Leitung gemäß des Oberbegriffs des Patentanspruchs 1 sowie ein Verfahren zur elektrischen Anbindung von Hochfrequenz-(HF-) Spulen mittels einer symmetrischen abgeschirmten Leitung.

Steigerung der Auflösung von Magnetresonanztomographie-(MRT-) Verfahren werden MRT-Anlagen (z.B. in der medizinischen Diagnostik) mit größeren Amplituden $B_0$ des statischen Magnetfelds konzipiert. Insbesondere bei Untersuchungen am Menschen, z.B. für medizinische Zwecke oder Forschungszwecke, sind große Auflösungen erwünscht, so dass die Magnetfeldstärke für derartige Geräte in der Vergangenheit ständig vergrößert wurde. Derzeit sind für Forschungszwecke MRT-Anlagen in Betrieb, die ein Magnetfeld von 7 T und sogar mehr erzeugen können.

Ein analoger Trend ist auch bei Kernresonanz- (NMR-) Spektrometern zu beobachten.

Außerdem besteht bei MRT-Anlagen - unabhängig von der Feldstärke - ein Trend zu einer steigenden Anzahl an Hochfrequenz-(HF-) Kanälen. Eine Vielzahl an Kanälen kann beispielsweise für eine Darstellung sich schnell bewegender Organe wie des Herzens vorteilhaft sein.

Sowohl die zunehmende Feldstärke als auch die steigende Anzahl an HF-Kanälen führen zu einer wachsenden Komplexität der MRT-Anlagen und insbesondere der notwendigen HF-Spulen. Diese HF-Spulen werden gelegentlich auch als "Antennen" oder als "Nahfeld-Antennen" bezeichnet und sind üblicherweise aus vielen einzelnen Elementen (z.B. 8 - 32 oder sogar mehr) aufgebaut. Derartige Systeme sind beispielsweise in Roemer, P. B. et al., "The NMR phased array", Magnetic Resonance in Medicine 16, 192 - 225 (1990) und Vaughan, J. T. et al., "RF Coils for MRI", Wiley, London (2012) beschrieben.

Derartige mehrkanalige Spulenarrays werden sowohl für das Senden von HF-Pulsen zur Anregung des Spinsystems als auch für den Empfang des hochfrequenten Kernresonanz-Signals genutzt.

Ackerman, J. J. H. et al., "Mapping of metabolites in whole animals by 31P NMR using surface coils". Nature 283, 167 - 170 (1980) beschreibt, dass als aktive Elemente einer HF-Spule bzw. eines HF-Spulenarrays für die MRT auf die Lamor-Frequenz abgestimmte resonante Anordnungen wie z. B. einfache Leiterschleifen ("Loops") genutzt werden können. Aus Hayes, C. E. et al., "An efficient, highly homogeneous radiofrequency coil for whole-body NMR imaging at 1.5 T", Journal of Magnetic Resonance 63, 622 - 628 (1985) sind dafür geeignete "Birdcage-Konfigurationen" bekannt. Außerdem können Streifenleiter (R. F. Lee, R. F. et al., "Planar strip array (PSA) for MRI", Magnetic Resonance in Medicine 45, 673 - 683 (2001) und Driesel, W. et al., "A microstrip helmet coil for human brain imaging at high magnetic field", Concepts in Magnetic Resonance Part B (Magnetic Resonance Engineering) 33B, 94 - 108 (2008)), Dipole (Raaijmakers, A. J. E. et al., "Design of a radiative surface coil array element at 7 T: The single-side adapted dipole antenna" Magnetic Resonance in Medicine 66, 1488 - 1497 (2011)) oder für spezielle Experimente auch Patch-Antennen (Brunner, D. O. et al., "Travelling wave nuclear magnetic resonance" Nature 457, 994 - 999 (2009)) verwendet werden. Unabhängig davon, welche dieser aktiven Elemente verwendet werden, sind diese durch Speiseleitungen mit der Sende- bzw. Empfangseinrichtung der MRT-Anlage verbunden. Üblicherweise sind dafür unsymmetrische koaxiale Speiseleitungen vorgesehen.

In der Praxis hat sich jedoch gezeigt, dass häufig unerwünschte Verkopplungen der aktiven Elemente mit den Speiseleitungen auftreten, was zu einer Verschlechterung der Spuleneigenschaften beim Senden und/oder Empfang führt. Da diese Kopplungen insbesondere bei sehr großen Feldstärken darüber hinaus ein relevantes Sicherheitsproblem darstellen, sind geeignete Gegenmaßnahmen notwendig.

Aus dem Stand der Technik ist bekannt, dass eine Verringerung des Koppelfaktors k zwischen einem aktiven Element und einer Speiseleitung als eine solche Gegenmaßnahme wirken kann. Eine Möglichkeit, den Koppelfaktor zur Speiseleitung zu reduzieren, besteht in einer elektrisch symmetrischen Speisung der aktiven Elemente. Realisiert wird dies bei koaxialen Speiseleitungen oft durch symmetrierende Anpassungsschaltungen oder einen Balun (balun = balanced-unbalanced) zur Wandlung zwischen einem symmetrischen und einem asymmetrischen Leitungsabschnitt als Symmetrierglied im Speisepunkt. Picard, L. et al., beschreiben in "Improvements in electronic decoupling of transmitter and receiver coils" Journal of Magnetic Resonance, Series B 106, 110 - 115 (1995) die Verwendung symmetrischer Speiseleitungen.

Theoretisch könnte der Koppelfaktor auch durch räumliche Symmetrie, vergrößerte Abstände oder Abschirmmaßnahmen verringert werden, was jedoch bei mehrkanaligen Spulenarrays nicht uneingeschränkt möglich ist. Eine perfekte sowohl elektrische als auch räumliche Symmetrie ist gleichzeitig für jedes einzelne Element gegenüber allen Speiseleitungen bei komplexen (mehrkanaligen) Systemen in der Praxis nicht realisierbar.

Für eine modellhafte Betrachtung kann vereinfacht jede Speiseleitung als Teil eines parasitären Leitungsresonators mit einer oder mehreren Resonanzfrequenzen angesehen werden. In Spulenarrays mit mehreren aktiven Elementen und mehreren Speiseleitungen kann eine Vielzahl unterschiedlicher parasitärer Moden mit jeweils verschiedenen Resonanzfrequenzen angeregt werden (z. B. Monopol-, Dipol sowie verschiedene Multipol-Moden). Die Stärke der Kopplung ist gemäß Gleichung 1 abhängig vom Koppelfaktor:

$$k = M/\sqrt{L_p L_s} \; . \hspace{3cm} (1)$$

Außerdem beeinflussen auch Gütefaktoren und die Verstimmung von aktivem Element und Speiseleitungsmoden den Koppelfaktor. In Gleichung 1 bezeichnen $L_p$ und $L_s$ die Induktivitäten des Primärkreises (beispielsweise ein aktives Element des Arrays) und des Sekundärkreises (beispielsweise eine Speiseleitung des Arrays als Teil eines parasitären Resonators). M steht für die Gegeninduktivität der Kreise. Weiterhin ist bekannt, dass eine Kopplung nicht nur induktiv erfolgen kann, sondern auch kapazitiv oder resistiv. Zur Berücksichtigung dieser Faktoren kann der Koppelfaktor gemäß Gleichung 2 verallgemeinert werden.

$$k = Z_m/\sqrt{Z_p Z_{s'}} \hspace{3cm} (2)$$

Dabei stehen $Z_m$ für die gemeinsame Impedanz und $Z_p$ und $Z_s$ für die Impedanzen des Primär- bzw. Sekundärkreises. Für HF-Spulen oder HF-Spulenarrays wie sie oben beschrieben wurden, wird eine sehr geringe und damit stark unterkritische Kopplung angestrebt. Der kritische Koppelfaktor kann im Fall einer Kopplung zweier Kreise mit gleicher Resonanzfrequenz durch Gleichung 3 beschrieben werden:

$$k_{crit} = 1/\sqrt{Q_p Q_s} \; . \hspace{3cm} (3)$$

$Q_p$ und $Q_s$ stehen dabei für die Güten des Primär- bzw. des Sekundärkreises. Für ein beispielhaftes System mit $Q_p = Q_s = 100$, was eine typische Größenordnung für HF-Spulen für die MRT darstellt, ergibt sich so ein kritischer Koppelfaktor von lediglich 0,01.

Wie aus Gleichung 3 und dem obigen Beispiel ersichtlich ist, führen kleine Güten zu großen Werten für $k_{crit}$. Demnach lässt sich eine stark unterkritische Kopplung bei geringeren Güten des Primär- bzw. des Sekundärkreises leichter realisieren. Der Bereich in dem die kritische Kopplung nicht erreicht wird, also die Bedingung $k < k_{crit}$, vorteilhaft sogar $k \ll k_{crit}$, erfüllt ist, vergrößert sich bei geringen Güten. Geringere Güten sind daher im Bezug auf geringe Kopplungen vorteilhaft.

Dennoch ist es nachteilig, die Güte des Primärkreises $Q_p$ gezielt zu verschlechtern, da dies auch zu einer Verringerung des Wirkungsgrades im Sendefall und zu einem schlechterem Signal-zu-Rausch-Verhältnis (signal-to-noise ratio, SNR) im Empfangsfall führt.

Wie von Terman, F. E. in "Radio Engineering" McGraw-Hill, New York, S. 76 - 85 (1937) und Mispelter, J. et al., in "NMR Probeheads for Biophysical and Biomedical Experiments" Imperial College Press, London (2006) beschrieben ist, ist die Kopplung ebenfalls reduziert, wenn die koppelnden Resonanzkreise gegeneinander verstimmt sind.

Aus dem Stand der Technik ist weiterhin bekannt, dass sich aus einer Betrachtung der durch die Kopplung induzierten Ströme Anhaltspunkte für eine günstige Beeinflussung von unerwünschten Kopplungen ergeben. Die Ströme eines Nutzsignals sind auf den Hin- und Rückleitern (bei Koaxialkabeln entsprechen diese beispielsweise dem Innenleiter bzw. der Schirminnenseite) stets gleich groß und fließen gegenphasig. Anders als die Ströme eines Nutzsignals sind die durch unerwünschte Kopplungen induzierten Ströme gleichphasig und bei abgeschirmten Leitungen durch Stromverdrängung auf der Schirmaußenseite konzentriert. Dementsprechend leitet sich daraus der Begriff "Mantelwelle" ab.

Weiterhin sind aus dem Stand der Technik sogenannte "Mantelwellensperren" bekannt, die gemeinsam haben, dass sie bei einer Leitung die Gleichtaktströme wenig, die Gegentaktströme jedoch stark dämpfen. Da auch Baluns in einigen Ausführungsformen derartige Eigenschaften zeigen, werden Mantelwellensperren in der Literatur oft (fälschlicherweise allgemein) als Baluns bezeichnet.

Mantelwellensperren lassen sich hinsichtlich ihrer Bandbreite in Typen (i) breitbandige und (ii) resonante Mantelwellensperren einordnen, wobei letztere in der Regel schmalbandig sind. Breitbandige Mantelwellensperren basieren üblicherweise entweder (a) auf einer Erhöhung der Gleichtaktreaktanz oder (b) auf einer Erhöhung der Gleichtaktverluste. Eine Erhöhung der Gleichtaktreaktanz breitbandiger Mantelwellensperren (i) gemäß Variante (a) kann beispielsweise realisiert werden durch

- Ferrite,
- gewickelte Kabelsegmente (z. B. als Solenoid, Butterfly-Anordnung oder Toroid) oder
- aufgetrennte Leitungen mit integrierten Transformatoren.

Eine Erhöhung der Gleichtaktverluste breitbandiger Mantelwellensperren (i) gemäß Variante (b) kann beispielsweise realisiert werden durch

- Verwendung spezieller Koaxialkabel mit schlechter Leitfähigkeit der Außenseite des Außenleiters oder
- zwischen den Schirmen benachbarter Koaxialkabel angebrachte Widerstände.

Resonante (schmalbandige) Mantelwellensperren (ii) lassen sich als Gleichtaktsperrkreise realisieren. Beispiele dafür sind:

- triaxiale Sperrkreise,
- die Bildung von Sperrkreisen aus dem Koaxialkabel-Außenleiter und Kondensatoren oder
- induktiv angekoppelte Sperrkreise (sogenannte "floating traps").

Alle der oben genannten Mantelwellensperren weisen jedoch je nach Variante verschiedene jeweils systeminhärente charakteristische Einschränkungen auf, die ihre Einsatzmöglichkeiten begrenzen oder die Wirksamkeit der gewünschten Maßnahme negativ beeinflussen. Nachteile der oben genannten Mantelwellensperren sind im Folgenden umrissen:

- Breitbandige ferromagnetische Ferrit- oder Pulvereisenkerne werden im großen Maßstab in der Technik eingesetzt, da sie bei guter Effizienz kompakt und kostengünstig zu realisieren sind. Die Verwendung derartiger Systeme ist jedoch im Bereich der starken Magnete einer MRT- oder NMR-Anlage wegen der starken Wechselwirkung mit deren statischen Magnetfeldern ausgeschlossen.
- Die Erhöhung der Gleichtaktinduktivität durch gewickelte Kabelsegmente der Speiseleitung (z.B. zu einem Solenoid oder Toroid) ist durch den dadurch beanspruchten Platzbedarf limitiert. Dennoch wird dies z.B. bei Empfangsspulen (z. B. in kommerziellen Vorverstärkern) genutzt. Da derartige Anordnungen (insbesondere Solenoide) jedoch zu neuen unerwünschten Kopplungen führen und zudem durch die systeminhärente Wicklungskapazität zusätzlich Resonanzeffekte hervorrufen, ist deren Verwendung in einer MRT- oder NMR-Anlage ebenfalls stark limitiert.
- Eine Unterbrechung der Gleichtaktströme durch Transformatoren führt zwangsläufig zu höheren Verlusten für das Nutzsignal und ist deshalb (insbesondere für hochauflösende) MRT- oder NMR-Experimente nicht sinnvoll einsetzbar.
- Systeme, wie z.B. in US 6,982,378 B2 oder von Boskamp, E. B. et al. "Broadband damping of cable modes", Proceedings of the 20th Annual Meeting of ISMRM, Melbourne, S. 2691 (2012) beschrieben, sind sehr aufwändig und/oder aufgrund der speziellen (kostenintensiven) Materialien oder Kabel unwirtschaftlich. Zudem sind die Eigenschaften durch die Wahl des Material festgelegt und nicht in einfacher Weise auf spezielle Erfordernisse anpassbar.
- Widerstände zwischen den Abschirmungen benachbarter Koaxialkabel wirken nur in dem Spezialfall, dass benachbarte Speiseleitungen parasitär im Gegentaktmodus angeregt werden.

Da wie oben beschrieben keine der breitbandigen Mantelwellensperren uneingeschränkt für einen Einsatz im Bereich der NMR oder MRT geeignet ist, werden für HF-Spulen in der Regel schmalbandige (resonante) Mantelwellensperren verwendet. Wie oben dargelegt, sind jedoch auch deren Einsatzbereiche limitiert und zum Teil mit erheblichen Nachteilen verbunden.

Insbesondere bei hochfeld MRT- und NMR-Anlagen bestehen im Zusammenhang mit dem Einsatz von HF Spulenarrays zahlreiche Limitierungen. Eine bei diesen Anlagen besondere Anforderung an Mantelwellensperren resultiert aus der großen Anzahl der Kanäle deren Arrays. Diese machen es besonders bei kleinen Wellenlängen $\lambda$ notwendig, dass eine sehr große Anzahl Mantelwellensperren eingesetzt werden muss, was aufgrund des begrenzten Volumens (bedingt durch den Aufbau eines NMR- oder MRT-Magneten mit relativ enger Proben- bzw. Patientenöffnung) nicht uneingeschränkt möglich ist. Da entsprechend der Larmor-Bedingung (Gleichung 4)

$$\omega_0 = \gamma B_0 \qquad\qquad (4)$$

die Resonanzfrequenz $\omega_0$ einer Kernsorte mit gyromagnetischem Verhältnis $\gamma$ linear mit der Feldstärke ansteigt und demzufolge die Wellenlänge der HF reziprok mit $B_0$ abnimmt, ist die praktische Umsetzung bei hohen Feldstärken mit besonderen Problemen verbunden, die mit den bisher aus dem Stand der Technik bekannten Systemen nicht zufriedenstellend ausgeräumt werden konnten.

Eine weitere Problematik bei den aus dem Stand der Technik bekannten Systemen besteht darin, dass resonante Mantelwellensperren ihrerseits parasitär mit den aktiven Elementen und auch untereinander koppeln können. Dies führt zu einer Verschlechterung der Wirkung, bis hin zur völligen Unbrauchbarkeit der Anordnung. Die parasitäre Kopplung resonanter Mantelwellensperren mit aktiven Elementen und/oder untereinander erfordert daher zusätzliche Maßnahmen zu deren Unterbindung. Dies kann beispielsweise durch eine spezielle räumliche Anordnungen der Komponenten zueinander, zusätzliche Abschirmungen oder eine gewisse gegenseitige Verstimmung erfolgen, wobei derartige Maßnahmen ebenfalls Nachteile (wie z.B. hohe Kosten) aufweisen, aufgrund der räumlichen Begrenzung nicht (oder nicht vollständig) umgesetzt werden können und darüber hinaus nicht in jedem Fall erfolgreich eingesetzt werden können.

Die Patentanmeldung US 2011/243255 A1 offenbart, dass durch die Überbrückung der Abschirmungen benachbarter Koaxialkabel und Anbringung eines EMI Filters die in den Abschirmungen auftretenden Ströme reduziert werden können.

Weiterhin sind aus den Patentanmeldungen DE 60 2004 007641 T2, US 2010/329527 A1 und WO 2011/051872 A2 Außenleiter bekannt, welche mit Zweipolen überbrücken sind.

US2011/037471 A1 offenbart eine Vorrichtung umfassend Koaxialkabel und einen Balun mit Unterbrechungen und Überbrückungen.
Der vorliegenden Erfindung liegt daher die Aufgabe zugrunde, eine Vorrichtung sowie ein Verfahren zur Speisung von HF-Spulen mittels symmetrischer abgeschirmter Leitungen bereit zu stellen, das die oben genannten Nachteile nicht aufweist.

Diese Aufgabe wird gelöst durch eine symmetrische abgeschirmte Leitung gemäß Patentanspruch 1.

Eine solche symmetrische abgeschirmte Leitung zur elektrischen Anbindung von elektronischen Baugruppen, Komponenten oder Peripheriegeräten umfasst zwei Innenleiter für mindestens ein Nutzsignal und eine Abschirmung, wobei beide Innenleiter mittels der Abschirmung gegenüber Einflüssen äußerer elektromagnetischer Wechselfelder abgeschirmt sind. Die Abschirmung weist an mindestens einer Stelle eine Unterbrechung auf, die mit einem verlustbehafteten oder verlustfreien Zweipol überbrückt ist. Dadurch sind im Vergleich zu einem Zustand ohne die Unterbrechung in der Abschirmung auftretende parasitäre Ströme effektiv reduziert. Eine solche symmetrische abgeschirmte Leitung wird im Folgenden gelegentlich auch vereinfacht als "Vorrichtung" bezeichnet.

Eine solche symmetrische abgeschirmte Leitung ist insbesondere auch in der Umgebung von starken Magnetfeldern geeignet, auf begrenztem Raum eine gute Abschirmung der Nutzsignale bereitzustellen und andererseits in Kombination mit HF-Spulen und/oder Antennen generierte Störungen wirkungsvoll zu unterbinden oder wenigstens zu reduzieren. Bevorzugt ist daher die elektrisch angebundene Komponente ein Teil oder ein Peripheriegerät einer MRT- oder NMR-Anlage.

Bevorzugt kann eine solche symmetrische abgeschirmte Leitung daher dazu genutzt werden, um Signale von oder zu Komponenten eines MRT- oder NMR-Gerätes zu leiten. Bevorzugt ist eine solche MRT- oder NMR-Anlage in der Lage, Magnetfelder einer Stärke von einigen Tesla (z.B. 0,1 T, 1 T, 3 T, 7 T oder sogar mehr) zu erzeugen. Dadurch ergeben sich Resonanzfrequenzen bei der Protonenresonanz ($^1$H-NMR oder MRT) von 4,2 - 300 MHz oder sogar darüber. Bevorzugt ist eine solche symmetrische abgeschirmte Leitung daher dazu geeignet, Signale von oder zu Komponenten einer MRT- oder NMR-Anlage zu leiten, die zur Erzeugung von Magnetfeldern stärker als 1 T, bevorzugt stärker als 3 T, besonders bevorzugt mindestens 7 T geeignet ist.

Als Komponente soll dabei und im Folgenden jeweils ein Teil eines solchen Gerätes aber auch ein Peripheriegerät verstanden werden. Eine mittels einer oben beschriebenen symmetrischen abgeschirmten Leitung angebundene Komponente eines solchen Gerätes ist bevorzugt eine elektronische Baugruppe. Eine solche Komponente im Sinne eines Teils eines solchen Gerätes kann beispielsweise eine (HF-) Spule, eine (HF-) Antenne, ein Spulen-Array, ein Antennen-Array, eine in das Gerät integrierte Kommunikationseinrichtung, eine in das Gerät integrierte Kamera, ein in das Gerät integrierter Bewegungssensor, eine in das Gerät integrierte Video und/oder Bildanzeigeeinrichtung, ein in das Gerät integrierter Lautsprecher, ein in das Gerät integriertes Mikrophon, eine in das Gerät integrierte Erfassungseinrichtung für physiologische Signale wie beispielsweise ein Wärmesensor, ein Blutdrucksensor, ein Lagesensor und/oder ein Pulsmessgerät sein. Eine solche Komponente im Sinne eines Peripheriegeräts einer solchen Anlage kann jedes Gerät sein, das im Einflussbereich des starken statischen Magnetfeldes und/oder des elektromagnetischen Wechselfeldes angeordnet ist, das durch das magnetfelderzeugende und/oder das das elektromagnetische Wechselfeld erzeugende Gerät generiert wird. Beispielsweise kann ein solches Peripheriegerät eine externe Kommunikationseinrichtung, eine externe Kamera, ein externer Bewegungssensor, eine externe Video- und/oder Bildanzeigeeinrichtung, ein externer Lautsprecher, ein externes Mikrophon, eine externe Erfassungseinrichtung für physiologische Signale wie beispielsweise ein Wärmesensor, ein Blutdrucksensor, eine Blutzuckermesseinrichtung oder ein Pulsmessgerät sein. Als Peripheriegerät sollen jedoch auch externe Steuer- und Auswerteeinrichtungen wie z.B. Computer (einschließlich deren Peripheriegeräte wie z.B. Eingabegeräte (Tastatur, Maus, Trackball, Grafikpads, Touchpads etc.), Drucker, externe Speichermedien, Anzeigeeinrichtungen (z.B. Monitore)) gelten. Diese Steuer- und Auswerteeinrichtungen sind üblicherweise über eine Datenleitung mit dem magnetfelderzeugenden Gerät und/oder der Antenne bzw. Spule verbunden. Insbesondere für eine solche Datenleitung oder Leitungen der Steuer- und Auswerteeinrichtung zur Stromversorgung ist die symmetrische abgeschirmte Leitung geeignet.

Der Einsatz einer erfindungsgemäßen symmetrischen abgeschirmten Leitung ist ausdrücklich nicht auf Anwendungen in oder im Umfeld von HF-Spulen oder HF-Spulenarrays für die NMR bzw. MRT beschränkt. Wie oben erwähnt, können sich auch Vorteile in der Nutzung für andere elektrische Komponenten (z.B. als Speiseleitung für diese Komponenten) bieten. Diese können - müssen jedoch nicht zwingend - in Verbindung mit einer NMR- oder MRT-Anlage oder in deren direkten Umfeld eingesetzt und in räumlicher Nachbarschaft mit Komponenten des HF-Systems (z. B. einer HF-Spule oder einem HF-Spulenarray) betrieben werden. Beispielhafte Anwendung ist die Nutzung in Komponenten zur Präsentation audiovisueller Stimuli im Rahmen von so genannten funktionellen MRT-Experimenten oder zur Kommunikation mit Patienten während einer MRT-Untersuchung. Derartige Komponenten könnten beispielsweise eine Videobrille zur visuellen Präsentation, ein Kopfhörersystem zur Präsentation akustischer Signale, ein Mikrophon zur Aufzeichnung von verbalen Antworten eines Probanden oder auch eine Überwachungseinheit zur Aufzeichnung physiologischer Signale während einer MRT-Untersuchung sein. Anwendungen beispielsweise in der Antennentechnik, Radiotechnik, in HiFi-Geräten, Radaranlagen, Funkeinrichtungen, Mikrowellengeräten sind ebenfalls möglich. Andere Anwendungen mit anderen elektrischen Komponenten sind ebenfalls denkbar und die oben genannte Aufzählung hat lediglich beispielhaften Charakter.

Bevorzugt ist eine symmetrische abgeschirmte Leitung zur elektrischen Anbindung von elektronischen Baugruppen, Komponenten oder Peripheriegeräten, insbesondere einer HF-Spule und/oder HF-Antenne und/oder einem Spulen- und/oder Antennen-Array, die bevorzugt innerhalb der HF-Abschirmung (Faraday-Käfig) einer MRT-Anlage angeordnet sind und dem Streufeld einzelner oder mehrerer Elemente einer HF-Sendespule oder eines HF-Sendespulenarray ausgesetzt sind.

Symmetrische abgeschirmte Leitungen bei denen die Schirmung jeder Leitung an mindestens einer Stelle unterbrochen und diese Unterbrechung mittels eines elektrischen Zweipols überbrückt ist, sind insbesondere im Bereich hochfrequenter Streufelder, wie sie beispielsweise bei MRT- oder NMR-Geräten auftreten, vorteilhaft. Insbesondere bei den in diesen Geräten durchgeführten Analysen unter Ausnutzung der Kerninduktion bietet sich eine erfindungsgemäße symmetrische abgeschirmte Leitung an. Durch die bei diesen Analysemethoden auftretenden elektromagnetischen Wechselfelder können in elektrischen Leitungen erhebliche Störungen auftreten, die sich - wie oben dargestellt - mit herkömmlichen Methoden bisher nicht in ausreichendem Maße reduzieren lassen.

Eine erfindungsgemäße symmetrische abgeschirmte Leitung bietet sich daher insbesondere auch zur Speisung der aktiven Elemente einer HF-Spule bzw. eines HF-Spulenarrays und/oder einer HF-Antenne bzw. eines HF-Antennenarrays an. Da die Resonanzfrequenz des Kerns (abgesehen von dem (festgelegten) Verhältnis des magnetischen Dipolmoments des Kerns zu seinem Spin (gyromagnetisches Verhältnis)) proportional zur Stärke des Magnetfelds am Ort des Kerns ist, müssen die zur Detektion genutzten Resonanzfrequenzen bei sehr großen Feldstärken ebenfalls ansteigen. Die durch die HF-Spule bzw. das HF-Spulenarray (in Resonanzfrequenz) erzeugenden elektromagnetischen Wechselfelder haben daher insbesondere bei Hochfeld-MRT- oder NMR-Geräten aufgrund der hohen Frequenz einem zunehmenden negativen Einfluss auf die kabelgebundene Anbindung elektronischer Baugruppen, Komponenten oder Peripheriegeräte.

Eine wie oben beschriebene symmetrische abgeschirmte Leitung zur elektrischen Anbindung von elektronischen Baugruppen, Komponenten oder Peripheriegeräten mittels symmetrischer abgeschirmter Leitungen bietet insbesondere den Vorteil, dass deren Nutzung sowohl zur Anbindung einzelner HF-Spulen als auch für Spulenarrays möglich ist. Der Aufbau ist dabei kompakt und ohne kostenintensive Spezialteile realisierbar.

Bei der Anbindung von elektronischen Baugruppen, Komponenten oder Peripheriegeräten mittels abgeschirmter Leitungen trägt üblicherweise nur der Gegentaktstrom durch die Innenleiter zur Weiterleitung des Nutzsignals bei. Die Abschirmung soll die Innenleiter gegenüber äußeren elektromagnetischen Feldern abschirmen. Jeder Gleichtaktstrom entlang des Schirms ist parasitär.

Als besonders vorteilhaft hat sich die symmetrische abgeschirmte Leitung erwiesen, wenn die Leitung ein Twinaxialkabel oder ein Verbund mehrerer Koaxialkabel ist. Es ist dann besonders einfach möglich, den Schirm jeder Leitung an einer oder gegebenenfalls an mehreren Stellen mit einer Unterbrechung zu versehen. Eine solche Unterbrechung (gelegentlich auch als "gap" bezeichnet) ist im Verhältnis zur Wellenlänge bevorzugt elektrisch sehr kurz, so dass sich der Gegentakt-Wellenwiderstand der symmetrischen Leitung nicht merklich verändert und keine nennenswerten zusätzlichen Reflexionen und Verluste für das Nutzsignal auftreten. Bevorzugt weist eine Unterbrechung in der Abschirmung eine Länge von 0,001 - 50 mm, bevorzugt von 0,01 - 10 mm und besonders bevorzugt von 0,1 - 5 mm in Längsrichtung der Leitung auf. Die Unterbrechung in der Abschirmung ist bevorzugt um einen Faktor 1/X kleiner als die Wellenlänge des elektromagnetischen Wechselfeldes. Dabei ist X bevorzugt im Bereich 10 - 5000, weiter bevorzugt 100 - 2500, besonders bevorzugt 500 - 1500. Für die Signalübertragung auf dem Innenleiter beträgt für eine Frequenz von beispielsweise 300 MHz, wie sie in einigen MRT- oder NMR-Anlagen verwendet wird, bei einem typischen Verkürzungsfaktor durch das Dielektrikum des Kabels von 0,7 die Wellenlänge von 70 cm. Bei X = 1000 ergäbe sich demnach eine Länge der Unterbrechung von etwa 1 mm in Längsrichtung der Leitung. Analog ergäbe sich bei diesem Faktor eine Länge der Unterbrechung von etwa 0,75 mm bei einer Frequenz von 400 MHz.

Die mindestens eine Unterbrechung ist bevorzugt dort angeordnet, wo sich (u.a. in Abhängigkeit der Länge der Leitung) bei dem bevorzugt eingesetzten Frequenzbereich ein Maximum der Amplitude (Strombauch) der durch die eingestrahlte (Resonanz-) Frequenz induzierten (stehenden) Welle in der Leitung ausbilden würde, wenn keine Unterbrechung vorliegen würde. Bei Betrachtung der parasitären Ströme auf der Außenseite des Schirms ist das Dielektrikum im Wesentlichen Luft. Damit beträgt für eine Frequenz von beispielsweise 300 MHz, wie sie in einigen MRT- oder NMR-Geräten verwendet wird, die Wellenlänge etwa 100 cm.

Bevorzugt ist der die Unterbrechung überbrückende Zweipol ausgewählt aus einer Gruppe, die einen passiven linearen Zweipol (bevorzugt einen ohmschen Widerstand, einen induktiven Blindwiderstand und/oder einen kapazitiven Blindwiderstand), einen nichtlinearen Zweipol, einen mittels einer Stellgröße umschaltbaren Zweipol und einen mittels einer Stellgröße stufenlos veränderbaren Zweipol (bevorzugt eine PIN-Diode, eine Kapazitätsdiode oder einen Drehkondensator) umfasst.

Bei einer Überbrückung der Unterbrechung durch einen passiven linearen Zweipol (wobei prinzipiell jede denkbare Kombination aus ohmschem Widerstand (R), Induktivität (L), und Kapazität (C) verwendet werden kann) kann ausgenutzt werden, dass einerseits ein (ohmscher) Wirkwiderstand R die Resonanzgüte der Leitung für alle parasitären Moden drastisch reduzieren kann und andererseits bei einer Überbrückung der Unterbrechung durch einen Blindwiderstand (L und/oder C beeinflussend) die Resonanzfrequenzen der parasitären Moden verschoben werden können.

Veränderbare lineare Zweipole zur Überbrückung der Unterbrechung bieten die Möglichkeit, die Eigenschaften der Überbrückung in Abhängigkeit von äußeren Einflüssen oder bei Experimenten mit verschiedenen Resonanzfrequenzen (z.B. Entkopplungsexperimente) verändern zu können und so der symmetrischen abgeschirmten Leitung (Vorrichtung) die gewünschten Eigenschaften geben zu können. Es ist daher bevorzugt, dass zumindest ein Zweipol der Vorrichtung ein mittels einer Stellgröße umschaltbarer Zweipol oder ein mittels einer Stellgröße stufenlos veränderbarer Zweipol, besonders bevorzugt eine PIN-Diode, eine Kapazitätsdiode oder ein Drehkondensator ist.

Es kann weiterhin vorteilhaft sein, dass die symmetrische abgeschirmte Leitung zusätzlich mindestens einen Balun umfasst, der die symmetrische Leitung an den unsymmetrischen Ausgang oder Eingang eines HF-Senders oder HF-Empfängers anschließt.

Beispiele für Leitungen, bei denen (mindestens) eine Unterbrechung (und deren Überbrückung) besonders vorteilhaft ist, sind Twinaxialkabel, Kombinationen aus zwei Koaxialkabeln, symmetrische abgeschirmte Leitungen, symmetrische doppelt abgeschirmte Leitungen bei denen nur die äußere Abschirmung unterbrochen und überbrückt ist, symmetrische doppelt abgeschirmte Leitungen, bei der beide Abschirmungen unterbrochen und überbrückt sind, sowie mehrere abgeschirmte Leitungen, die in einer unterbrochenen und überbrückten gemeinsamen Außenabschirmung zusammengefasst sind.

In einer weiteren bevorzugten Ausführungsform weist eine wie oben beschriebene symmetrische abgeschirmte Leitung zusätzlich mindestens eine weitere (wie z.B. eine aus dem o.g. Stand der Technik bekannte) Mantelwellensperre auf. Durch eine solche Kombination ist es beispielsweise möglich, die Leistungsfähigkeit der Vorrichtung weiter zu steigern. Beispielsweise kann durch zwischen den Abschirmungen benachbarter Koaxialkabel eingeführte Widerstände eine Erhöhung der Gleichtaktverluste erreicht und so parasitäre Gegentaktmoden zusätzlich gedämpft werden. Als besonders vorteilhaft haben sich bei derartigen Ausführungsformen Anordnungen erwiesen, bei denen die Widerstände, über die die benachbarten Koaxialkabel miteinander verbunden sind, dort positioniert sind, wo ein Spannungsbauch lokalisiert ist.

Besonders bevorzugt ist die Verwendung einer wie oben beschriebenen symmetrische abgeschirmte Leitung zur elektrischen Anbindung von elektronischen Baugruppen, Komponenten oder Peripheriegeräten einer MRT- oder NMR-Anlage.

Ein weiterer wesentlicher Aspekt der Erfindung ist ein Verfahren zur elektrischen Anbindung von elektronischen Baugruppen, Komponenten oder Peripheriegeräten gemäß Patentanspruch 13.

Bei diesem Verfahren zur elektrischen Anbindung von elektronischen Baugruppen, Komponenten (10) oder Peripheriegeräten wird mindestens eine symmetrische abgeschirmte Leitung genutzt, die zwei Innenleiter für mindestens ein Nutzsignal und eine Abschirmung umfasst, wobei beide Innenleiter mittels der Abschirmung gegenüber Einflüssen eines elektromagnetischen Wechselfeldes abgeschirmt werden. Die Abschirmung wird an mindestens einer Stelle mit einer Unterbrechung versehen und diese mit einem verlustbehafteten oder verlustfreien Zweipol überbrückt, sodass dadurch im Vergleich zu einem Zustand ohne die Unterbrechung in der Abschirmung auftretende parasitären Ströme effektiv reduziert werden. Durch dieses Verfahren wird es möglich, besonders einfache und kompakte Systeme zu erzeugen, bei denen in einem begrenzen Raum durch eine gute Abschirmung der Nutzsignale gegenüber elektromagnetischen Wechselfeldern (z.B. durch HF-Spulen und/oder-Antennen generiert) wirkungsvoll realisiert werden kann. Die durch elektromagnetische Wechselfelder induzierten Störungen können unterbunden oder wenigstens reduziert werden. Insbesondere kann dadurch verhindert werden, dass in besonders komplexen Systemen Leitungen untereinander in Resonanz geraten und so ein gemeinsames Resonanzsystem besonders großer Komplexität entsteht.

Weitere Vorteile, Ziele und Eigenschaften vorliegender Erfindung werden anhand nachfolgender Beschreibung anliegender Zeichnung erläutert, in welcher beispielhaft eine erfindungsgemäße Vorrichtung zur Speisung von Hochfrequenz- (HF-) Spulen mittels symmetrischer abgeschirmter Leitungen dargestellt ist. Baugruppen der Vorrichtung zur Speisung von HF-Spulen mittels symmetrischer abgeschirmter Leitungen, welche in den Figuren wenigstens im Wesentlichen hinsichtlich ihrer Funktion übereinstimmen, können hierbei mit gleichen Bezugsziffern gekennzeichnet sein, wobei diese Baugruppen nicht in allen Figuren beziffert und erläutert sein müssen.

Es zeigt:

Fig. 1a    eine schematische Darstellung einer Kombination zweier Koaxialkabel mit einer Unterbrechung und Überbrückung der Abschirmung.

Fig. 1b    eine schematische Darstellung einer symmetrisch abgeschirmten Leitung mit einer Unterbrechung und Überbrückung der Abschirmung.

Fig. 1c    eine schematische Darstellung einer symmetrischen, doppelt abgeschirmten Leitung mit einer Unterbrechung und Überbrückung der äußeren Abschirmung.

Fig. 1d    eine schematische Darstellung einer symmetrischen, doppelt abgeschirmten Leitung mit einer jeweiligen Unterbrechung und Überbrückung beider Abschirmungen.

Fig. 1e    eine schematische Darstellung mehrerer innerhalb eines Außenschirms gebündelter, jeweils abgeschirmter Leitungen mit einer Unterbrechung und Überbrückung des Außenschirms.

Fig. 2     eine schematische Darstellung zweier Leitungen mit einer jeweiligen Unterbrechung und Überbrückung der Abschirmungen, deren benachbarte Außenleiter über ohmsche Widerstände verbunden sind.

Fig. 3a    eine schematische Darstellung einer quadratischen Leiterschleife als aktives Element einer HF-Spule mit einer symmetrischen Schaltung im Speisepunkt zur Abstimmung an den Gegentakt Wellenwiderstand der symmetrischen Speiseleitung mit unterbrochenem Schirm.

Fig. 3b    eine schematische Darstellung einer quadratischen Leiterschleife als aktives Element einer HF-Spule mit einer symmetrischen Speiseleitung mit unterbrochenem Schirm und einem am spulenfernen Ende der Speiseleitung angeordneten Balun,

Fig. 3c    eine schematische Darstellung einer quadratischen Leiterschleife als aktives Element einer HF-Spule mit einem symmetrischen Vorverstärker im Speisepunkt mit einer symmetrischen Speiseleitung mit unterbrochenem Schirm und einem am spulenfernen Ende der Speiseleitung angeordneten Balun.

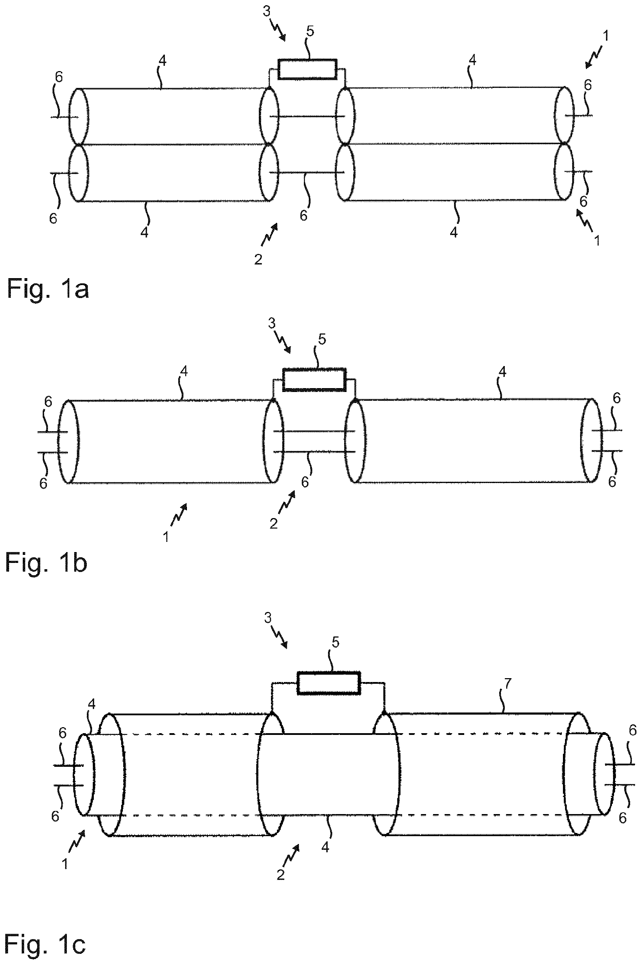

Fig. 1a zeigt eine schematische Darstellung einer Kombination zweier Koaxialkabel 1 mit einer Unterbrechung 2 und Überbrückung 3 der Abschirmung 4. Die Überbrückung 3 der Unterbrechung 2 erfolgt mittels eines elektrischen Zweipols 5, welcher beispielsweise ein ohmscher Widerstand sein kann. Die Innenleiter 6 sind nicht unterbrochen. Sie sind im Bereich der Unterbrechung 2 und Überbrückung 3 der Abschirmung 4 jedoch nicht von der (unterbrochenen) Abschirmung 4 umgeben. Im in Fig. 1a gezeigten Beispiel liegen die Innenleiter 6 im Bereich der Unterbrechung 2 frei. Die Unterbrechung 2 ist im Verhältnis zur Wellenlänge sehr kurz dimensioniert. Insbesondere ist sie auch so kurz, so dass der Gegentakt-Wellenwiderstand der symmetrischen Leitung durch die elektrisch sehr kurze Unterbrechung 2 nicht (oder nicht merklich oder nennenswert) verändert wird. Insbesondere können durch eine sehr kurze Unterbrechung 2 Reflexionen und/oder Verluste des (im Innenleiter 6 übertragenen) Nutzsignals auftreten.

Die eine Unterbrechung 2 oder auch mehrere Unterbrechungen 2 sind bevorzugt dort angeordnet, wo sich ein Strombauch der Mantelwellen befindet. Grundsätzlich erfordern längere Leitungen gegebenenfalls mehrere Unterbrechungen Der Strombauch bzw. das Maximum oder die Maxima der Mantelwelle variieren in Abhängigkeit von der Frequenz, durch welche sie induziert werden. Ist dies zu erwarten (z.B. bei Einsatz in einem sehr großen Frequenzbereich), so ist es vorteilhaft, mehrere Unterbrechungen 2 der Abschirmung 4 vorzusehen. Dadurch kann gewährleistet werden, dass unabhängig vom genauen Ort des Strombauchs der Mantelwellen (wie er ohne Unterbrechung im Außenleiter vorliegen würde) die Abschirmung 4 an Stellen unterbrochen ist, die die im Außenleiter auftretenden parasitären Ströme effektiv reduzieren.

Es sind alle denkbaren elektrischen Zweipole oder deren Kombinationen zur Überbrückung 3 geeignet. So sind alternativ oder auch zusätzlich zu dem oben beispielhaft genannten resistiven Zweipol 5 auch induktive und/oder kapazitive Zweipole 5 möglich.

Die Überbrückung 3 mit einem Wirkwiderstand R (z.B. einem ohmschen Widerstand) wirkt sich vorteilhaft auf die Resonanzgüte der Leitung für alle parasitären Moden auf, da diese dadurch drastisch verringert werden können. Die Überbrückung 3 der Unterbrechung 2 mit einem induktiven und/oder kapazitiven Zweipol (z.B. durch einen Blindwiderstand) kann die Resonanzfrequenz der parasitären Moden verschoben werden.

Zur Überbrückung 3 der Unterbrechung 2 sind auch nichtlineare Zweipole 5 geeignet. Durch diese ist es möglich, die Eigenschaften des Zweipols 5 pegelabhängig zu gestalten. Außerdem sind umschaltbare und/oder stufenlos veränderbare Zweipole 5 denkbar. Eine PIN-Diode (positive intrinsic negative-Diode) ermöglicht beispielsweise die Regelung über den Strom, eine Kapazitätsdiode ermöglicht die Regelung über die Spannung, oder ein Drehkondensator ermöglicht eine mechanische Regelung.

Fig. 1b zeigt eine schematische Darstellung einer symmetrisch abgeschirmten Leitung 1 mit einer Unterbrechung 2 und Überbrückung 3 der gemeinsamen Abschirmung 4. Im in Fig. 1b gezeigten Beispiel eines Twinaxialkabels 1 verlaufen zwei Innenleiter 6 gemeinsam in einer Abschirmung 4. Die gemeinsame Abschirmung weist eine Unterbrechung 2 und Überbrückung 3 auf. Die Überbrückung 3 kann wie zuvor in Bezug auf Fig. 1a beschrieben mittels jeden denkbaren Zweipols 5 realisiert werden. Es sind auch mehrere Unterbrechungen 2 möglich.

In Fig. 1c ist eine schematische Darstellung einer symmetrischen, doppelt abgeschirmten Leitung 1 mit einer Unterbrechung 2 und Überbrückung 3 der äußeren Abschirmung 7 gezeigt. Die innere Abschirmung 4 bleibt im Bereich der Unterbrechung 2 der äußeren Abschirmung 7 intakt. Dies hat zur Folge, dass die Innenleiter 6 auch im Bereich der Unterbrechung 2 abgeschirmt sind (durch die innere Abschirmung 4). Dadurch sind sie auch in diesem Bereich weniger anfällig gegenüber äußeren Einflüssen und mechanischen Belastungen. Die Überbrückung kann auch in diesem Fall durch einen Zweipol 5 realisiert werden.

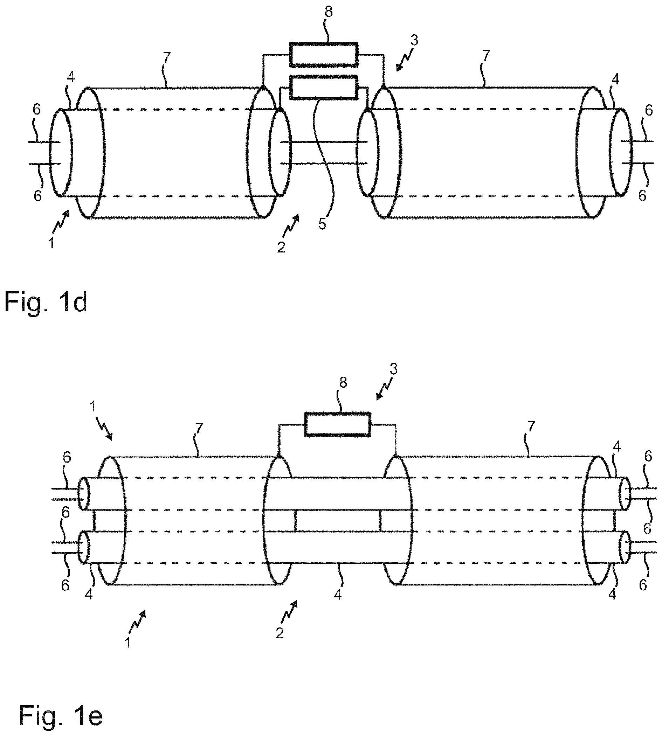

Fig. 1d zeigt eine schematische Darstellung einer symmetrischen, doppelt abgeschirmten Leitung 1 mit einer jeweiligen Unterbrechung 2 und Überbrückung 3 beider Abschirmungen 4, 7. Diese Ausführungsform weist den Vorteil auf, dass die Innenleiter 6 durch die beiden Abschirmungen 4 und 7 doppelt abgeschirmt sind und so besonders unempfindlich gegenüber externen Einflüssen sind. Beide Abschirmungen 4, 7 sind unterbrochen, so dass Gegentaktströme wirksam vermieden oder zumindest reduziert werden können. Für die Überbrückung 5 der inneren Abschirmung 4 kann ein Zweipol 5 genutzt werden. Ein solcher oder auch ein anderer Zweipol 8 ist auch für die Überbrückung 5 der äußeren Abschirmung 7 vorgesehen. Durch die Verwendung zweier verschiedener Zweipole ist es besonders vorteilhaft möglich, durch die Überbrückung 3 mit einem Wirkwiderstand R als einer der Zweipole 5, 8 einerseits eine Verringerung der Resonanzgüte der Leitung für alle parasitären Moden zu erreichen. Andererseits können durch eine Überbrückung 3 mit einem induktiven und/oder kapazitiven Zweipol als einer der Zweipole 5, 8 zum Verschieben der Resonanzfrequenz der parasitären Moden verschiedene Störeinflüsse besonders wirkungsvoll begrenzt werden.

In Fig. 1e ist eine schematische Darstellung mehrerer innerhalb eines Außenschirms gebündelter, jeweils abgeschirmter Leitungen 1 mit einer Unterbrechung 2 und Überbrückung 3 des Außenschirms 7 gezeigt. Die Anordnung ähnelt der in Fig. 1c gezeigten Darstellung. Die innere Abschirmung 4 der in diesem Beispiel zwei Kabel bleibt im Bereich der Unterbrechung 2 der äußeren Abschirmung 7 ebenfalls intakt. Dies bewirkt auch bei der in Fig. 1e gezeigten Anordnung, dass die Innenleiter 6 auch im Bereich der Unterbrechung 2 jeweils separat abgeschirmt sind (jeweils durch die den jeweiligen Innenleiter 6 umgebende innere Abschirmung 4). Dadurch sind sie auch in diesem Bereich weniger anfällig gegenüber äußeren Einflüssen und mechanischen Belastungen. Die Überbrückung kann auch in diesem Fall durch einen Zweipol 5 realisiert werden.

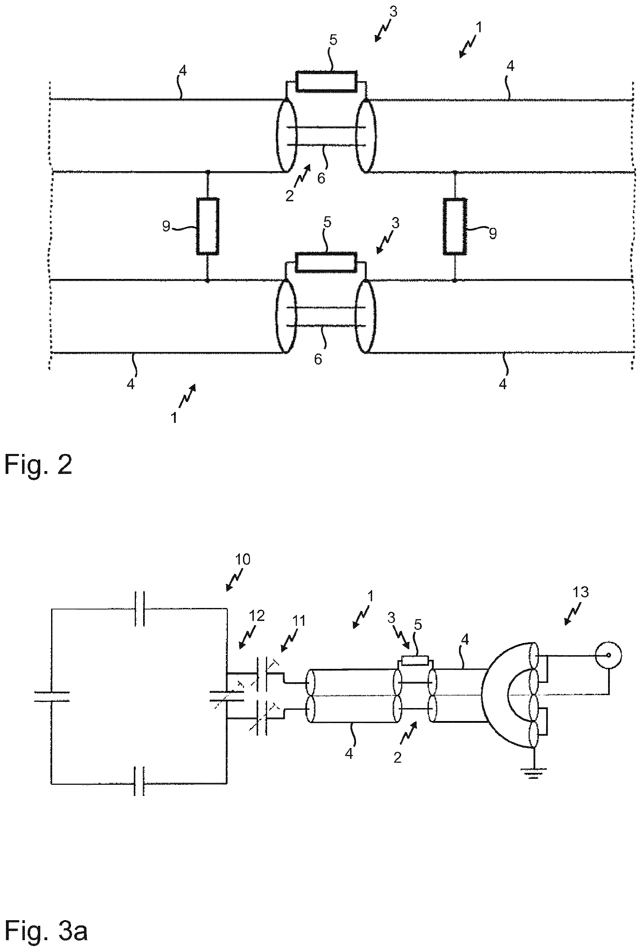

Fig. 2 ist eine schematische Darstellung zweier Leitungen (Koaxialkabel) 1 mit einer jeweiligen Unterbrechung 2 und Überbrückung 3 der jeweiligen Abschirmungen 4, deren benachbarte Außenleiter 4 über ohmsche Widerstände 9 verbunden sind. Durch eine derartige Anordnung ist es möglich, die (parasitären) Gleichtaktverluste zu erhöhen. Parasitäre Gegentaktmoden können gedämpft werden. Grundsätzlich lassen sich - wie bereits oben erwähnt - die oben genannten Speiseleitungen 1 mit unterbrochenem und durch einen Zweipol 5 überbrücktem Außenleiter 4 mit allen bekannten Mantelwellensperren kombinieren. Beispielsweise könnten Ferrite, Solenoide, Butterfly-Anordnungen oder andere Mantelwellensperren eingesetzt werden. Da diese jedoch - wie oben beschrieben - zum Teil große Nachteile aufweisen, sind Anordnungen bevorzugt, die auch bei starken Magnetfeldern wirksam einsetzbar sind. Daher ist insbesondere die in Fig. 2 gezeigte Anordnung bevorzugt, bei der die Abschirmung 4 mehrerer (bevorzugt) benachbarter Koaxialkabel 1 über (bevorzugt ohmsche) Widerstände 9 miteinander verbunden sind. Als besonders vorteilhaft haben sich bei derartigen Ausführungsformen erwiesen, bei denen die Widerstände 9, über die jeweils zwei verschiedene Koaxialkabel 1 miteinander verbunden sind, dort positioniert sind, wo ein Spannungsbauch lokalisiert ist.

Fig. 3a zeigt eine schematische Darstellung einer quadratischen Leiterschleife 10 als aktives Element einer HF-Spule mit einer symmetrischen Schaltung 11 im Speisepunkt 12 zur Abstimmung an den Gegentakt-Wellenwiderstand der symmetrischen Speiseleitung 1 mit unterbrochenem Schirm 4. Wie in Fig. 3a gezeigt ist, kann im Speisepunkt 12 des aktiven Elements 10 einer HF-Spule oder eines HF-Spulenarrays (in Fig. 3a als eine quadratische Leiterschleife mit vier verteilten Kondensatoren dargestellt) eine symmetrische Schaltung 11 angeordnet sein, welche die Abstimmung und die Anpassung an den Gegentakt-Wellenwiderstand der symmetrischen Speiseleitung 1 ermöglicht. Der Schirm dieser Leitung weist an (mindestens) einer Stelle eine Unterbrechung 2 auf. Wie in den Fig. 1a - 1e dargestellt und oben beschrieben, ist auch in diesem Beispiel die Unterbrechung 2, mit einem verlustbehafteten Zweipol 5 (z. B. mit einem ohmschen Widerstand) überbrückt. Auch in diesem Beispiel ist (bzw. sind) die Unterbrechung(en) bevorzugt in der Nähe oder an einer Position angeordnet, an der (ohne die Unterbrechung) ein Strombauch der Mantelwellen lokalisiert ist/wäre. Bei einer Lokalisierung in diesem Bereich ist die maximale Wirkung zu erwarten. Am spulenfernen Ende der symmetrischen Speiseleitung 1 ist ein Balun 13 angeordnet. In dem in Fig. 3a gezeigten Beispiel handelt es sich hierbei um eine λ/2-Umwegleitung.

Bevorzugt ist bei einer solchen Anordnung die symmetrische Speiseleitung 1 mindestens so lang, dass ein nach dem Balun angeschlossenes unsymmetrisches Koaxialkabel nicht mehr merklich mit den aktiven Elementen koppeln kann. Auch wenn in Fig. 3a nicht dargestellt, kann es (insbesondere bei mehrkanaligen Spulenarrays) vorteilhaft sein, die Abschirmungen mehrerer, bevorzugt aller Speiseleitungen 1 über (bevorzugt ohmsche) Widerstände miteinander zu verbinden, wie es analog in Fig. 2 dargestellt ist.

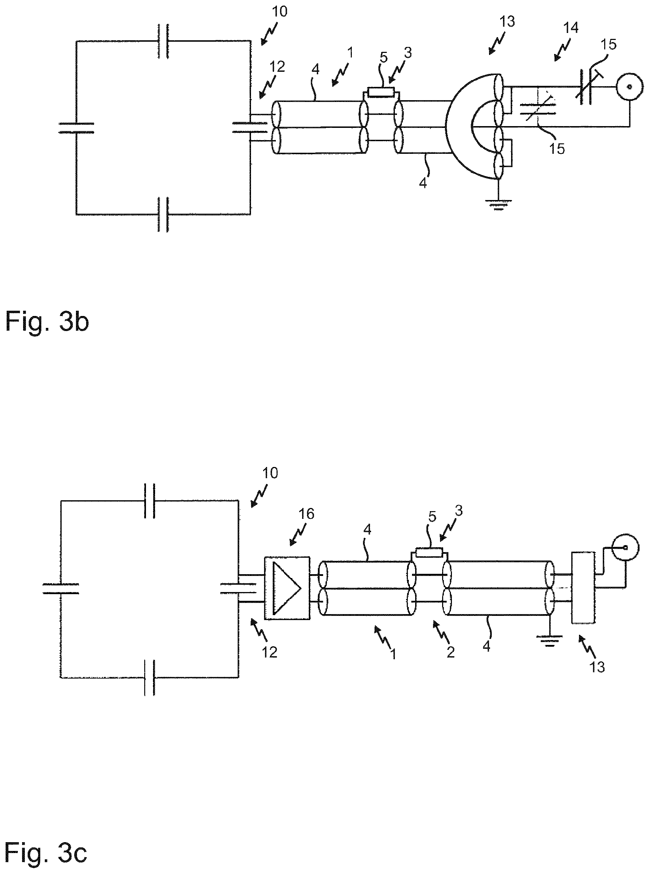

Fig. 3b zeigt eine schematische Darstellung einer alternativen Anbindung einer quadratischen Leiterschleife 10 als aktives Element einer HF-Spule über eine symmetrische Speiseleitung 1 mit unterbrochenem Schirm 4 mittels eines am spulenfernen Ende der Speiseleitung 1 angeordneten Balun 13.

In diesem Beispiel ist eine quadratische Leiterschleife 10 mit vier verteilten Kondensatoren ebenfalls mit einer abgeschirmten symmetrischen Leitung 1 verbunden. Im Gegensatz zu der in Fig 3a gezeigten Anordnung ist diese jedoch direkt mit der Leiterschleife verbunden, ohne dass eine symmetrische Schaltung 11 im Speisepunkt 12 zur Abstimmung an den Gegentakt-Wellenwiderstand vorgesehen ist. Die abgeschirmte symmetrische Leitung 1 kann wie im in Fig. 3a gezeigten Beispiel ein Twinaxialkabel oder mehrere Koaxialkabel umfassen. Beispielsweise können auch abgeschirmte verdrillte Leitungen vorgesehen sein. Wie auch bei den obigen Beispielen ist die Abschirmung 4 dieser Leitung 1 an (mindestens) einer Stelle (gegebenenfalls auch an mehreren Stellen) mit einer Unterbrechung 2 versehen, die mit einem verlustbehafteten Zweipol 5 (z. B. mit einem ohmschen Widerstand) überbrückt ist. Die Unterbrechung(en) 2 ist (sind) auch in diesem Beispiel bevorzugt dort angeordnet, wo (ohne die Unterbrechung) ein Strombauch der Mantelwellen lokalisiert ist/wäre. Die elektrische Länge der symmetrischen Leitung 1 beträgt bevorzugt N x $(\lambda/2)$. N ist dabei eine (bevorzugt kleine) natürliche Zahl (N $\geq$ 1). Am spulenfernen Ende der Leitung befindet sich ein Balun 13, der wie auch im zuvor in Fig. 3a dargestellten Ausführungsbeispiel als $\lambda/2$-Umwegleitung ausgeführt ist. Auf der der Speiseleitung 1 zur Spule abgewandten Seite des Balun 13 ist eine unsymmetrische Schaltung 14 zur Anpassung an den Wellenwiderstand Zo des unsymmetrischen Ausgangs des Senders bzw. des Eingangs des Empfängers angeordnet. Die Komplexität dieser Anordnung ist gegenüber der in Fig. 3a gezeigten reduziert, da die Anpassungsschaltung hinter dem Balun angeordnet ist. Die Anzahl der Baugruppen kann gegenüber dem in Fig. 3a gezeigten Ausführungsbeispiel reduziert sein, da wie in Fig. 3b gezeigt die unsymmetrische Schaltung 14 zur Anpassung an den Wellenwiderstand $Z_0$ zwei einfache Drehkondensatoren 15 ("Trimmer") umfassen kann. Da die Anpassungs- und Abstimmprozesse nur durch die Eigenschaften des Baluns bestimmt werden, wird durch sie die Symmetrie der Leitung 1 nicht verändert.

Der in Fig. 3b gezeigte Balun ist beispielsweise so konfiguriert, dass er Impedanzen im Verhältnis 4:1 transformiert. Dementsprechend werden für die Trimmer etwa vierfach höhere Kapazitätswerte (gegenüber einer Ausführungsform ohne zusätzliche Transformatoren) benötigt.

Durch die wie oben beschriebenen Ausführungsformen wird es möglich, eine besonders große Anzahl geeigneter Bauelemente zu nutzen, was zu einer großen Flexibilität bei deren Auswahl führt. Insbesondere beim Design von Speiseleitungen für HF-Spulen oder Spulenarrays zur Verwendung in starken MRT- (bzw. NMR-) Geräten, die bei sehr großen Feldstärken (von z.B. 7 T oder sogar mehr) arbeiten, ist dies von großem Vorteil.

Fig. 3c zeigt eine schematische Darstellung einer quadratischen Leiterschleife 10 als aktives Element einer HF-Spule mit einem symmetrischen Vorverstärker 16 im Speisepunkt 12 mit einer symmetrischen Speiseleitung 1 mit unterbrochenem Schirm 4 und einem am spulenfernen Ende der Speiseleitung 1 angeordneten Balun 13.

Auch in diesem Beispiel ist eine quadratische Leiterschleife 10 mit vier verteilten Kondensatoren mit einer abgeschirmten symmetrischen Leitung 1 verbunden. Wie auch in der in Fig. 3a gezeigten Anordnung ist diese nicht direkt mit der Leiterschleife verbunden. Wie in Fig. 3c gezeigt, kann im Speisepunkt 12 ein symmetrischer Vorverstärker 16 zur Abstimmung an den Gegentakt-Wellenwiderstand vorgesehen sein. Die abgeschirmte symmetrische Leitung 1 ist wie auch in den in den Fig. 3a und 3b gezeigten Beispielen ein Twinaxialkabel oder ein Bündel mehrerer Koaxialkabel. Die Abschirmung 4 dieses Twinaxialkabels oder Koaxialkabelbündels ist wie auch in den obigen Beispielen an (mindestens) einer Stelle (gegebenenfalls auch an mehreren Stellen) durch eine Unterbrechung 2 diskontinuierlich ausgebildet und jeweils mit einem verlustbehafteten oder verlustfreien Zweipol 5 (z. B. mit einem ohmschen Widerstand) überbrückt. Auch bei diesem Beispiel ist/sind die Unterbrechung(en) 2 bevorzugt dort angeordnet, wo (ohne die Unterbrechung) ein Strombauch der Mantelwellen lokalisiert ist/wäre. Am spulenfernen Ende der Leitung befindet sich ein Balun 13.

Sämtliche in den Anmeldungsunterlagen offenbarten Merkmale werden als erfindungswesentlich beansprucht, sofern sie einzeln oder in Kombination gegenüber dem Stand der Technik neu sind.

## Bezugszeichenliste

1  Leitung, Koaxialkabel, Twinaxialkabel
2  Unterbrechung
3  Überbrückung
4  (innere) Abschirmung
5  Zweipol

6 Innenleiter
7 (äußere) Abschirmung
8 Zweipol
9 (ohmscher) Widerstand
10 Leiterschleife, aktives Element einer HF-Spule
11 symmetrische Schaltung
12 Speisepunkt
13 Balun
14 unsymmetrische Schaltung
15 Drehkondensator, Trimmer

**Patentansprüche**

1. Symmetrische abgeschirmte Leitung (1) zur elektrischen Anbindung von elektronischen Baugruppen, Komponenten (10) oder Peripheriegeräten umfassend zwei Innenleiter (6) für mindestens ein Nutzsignal und eine Abschirmung (4), wobei beide Innenleiter (6) mittels der Abschirmung (4) gegenüber Einflüssen eines elektromagnetischen Wechselfeldes abgeschirmt sind,
**dadurch gekennzeichnet, dass**
die Abschirmung (4) an mindestens einer Stelle eine Unterbrechung (2) aufweist, die mit einem verlustbehafteten oder verlustfreien Zweipol (5) überbrückt ist, sodass dadurch im Vergleich zu einem Zustand ohne die Unterbrechung in der Abschirmung (4) auftretende parasitäre Ströme effektiv reduziert sind.

2. Symmetrische abgeschirmte Leitung (1) nach Anspruch 1, **dadurch gekennzeichnet, dass** die symmetrische abgeschirmte Leitung (1) zur elektrischen Anbindung einer Komponente geeignet ist, welche ein Teil oder ein Peripheriegerät eines MRT- oder NMR-Gerätes ist.

3. Symmetrische abgeschirmte Leitung (1) nach Anspruch 2, **dadurch gekennzeichnet, dass**
das MRT-oder NMR-Gerät zur Erzeugung von Magnetfeldern stärker als 0,1 T, bevorzugt stärker als 3 T, besonders bevorzugt 7 T oder stärker geeignet ist.

4. Symmetrische abgeschirmte Leitung (1) nach Anspruch 2 oder 3, **dadurch gekennzeichnet, dass**
die Komponente, das Teil oder das Peripheriegerät des MRT- oder NMR-Gerätes ausgewählt ist aus einer Gruppe, die eine HF-Spule und/oder HF-Antenne, ein Spulen- und/oder Antennen-Array, Steuerelektronik, eine Kommunikationseinrichtung, eine Kamera, einen Bewegungssensor, eine Video und/oder Bildanzeigeeinrichtung, einen Lautsprecher, ein Mikrophon, eine Erfassungseinrichtung für physiologische Signale, bevorzugt einen Wärmesensor, einen Blutdrucksensor, einen Lagesensor und/oder einen Pulsmessgerät einschließt.

5. HF-Spule und/oder HF-Antenne und/oder Spulen- und/oder Antennen-Array, elektrisch angebunden mittels der symmetrischen abgeschirmten Leitung (1) nach einem der vorangegangenen Ansprüche.

6. Symmetrische abgeschirmte Leitung (1) nach einem der Ansprüche 1-4, **dadurch gekennzeichnet, dass**
die symmetrische abgeschirmte Leitung (1) ein Twinaxialkabel oder ein Verbund mehrerer Koaxialkabel ist.

7. Symmetrische abgeschirmte Leitung (1) nach einem der Ansprüche 1-4 und 6, **dadurch gekennzeichnet, dass**
der die Unterbrechung (2) überbrückende verlustbehaftete Zweipol (5) ausgewählt ist aus einer Gruppe, die einen passiven linearen Zweipol, bevorzugt einen ohmschen Widerstand, Blindwiderstand, Induktivität L, und/oder Kondensator, einen nichtlinearen Zweipol, einen mittels einer Stellgröße umschaltbaren Zweipol und einen mittels einer Stellgröße stufenlos veränderbaren Zweipol, bevorzugt eine PIN-Diode, eine Kapazitätsdiode oder einen Drehkondensator umfasst.

8. Symmetrische abgeschirmte Leitung (1) nach einem der Ansprüche 1-4, 6 und 7, **dadurch gekennzeichnet, dass**
die Vorrichtung weiterhin mindestens einen Balun umfasst.

9. Symmetrische abgeschirmte Leitung (1) nach einem der Ansprüche 1-4 und 6-8, **dadurch gekennzeichnet, dass**
die Vorrichtung mindestens eine weitere Mantelwellensperre aufweist.

10. Symmetrische abgeschirmte Leitung (1) nach einem der Ansprüche 1-4 und 6-9, **dadurch gekennzeichnet, dass** die Unterbrechung (2) eine Länge von 0,001 - 50 mm, bevorzugt von 0,01 - 10 mm und besonders bevorzugt von 0,1 - 5 mm in Längsrichtung der symmetrischen abgeschirmten Leitung (1) aufweist.

11. Symmetrische abgeschirmte Leitung (1) nach einem der Ansprüche 1-4 und 6-10, **dadurch gekennzeichnet, dass** mindestens eine Unterbrechung dort angeordnet ist, wo sich in der Abschirmung (4) der symmetrischen abgeschirmten Leitung (1) in Wechselwirkung mit dem elektromagnetischen Wechselfeld ein Maximum der Amplitude der durch das elektromagnetische Wechselfeld induzierten Welle ausbilden würde, wenn keine Unterbrechung vorliegen würde.

12. Verwendung der symmetrischen abgeschirmten Leitung (1) nach einem der Ansprüche 1-4 und 6-11, zur elektrischen Anbindung von elektronischen Baugruppen, Komponenten (10) oder Peripheriegeräten eines MRT- oder NMR-Gerätes.

13. Verfahren zur elektrischen Anbindung von elektronischen Baugruppen, Komponenten (10) oder Peripheriegeräten mittels mindestens einer symmetrischen abgeschirmten Leitung (1), die zwei Innenleiter (6) für mindestens ein Nutzsignal und eine Abschirmung (4) umfasst, wobei beide Innenleiter (6) mittels der Abschirmung (4) gegenüber Einflüssen eines elektromagnetischen Wechselfeldes abgeschirmt werden,
**dadurch gekennzeichnet, dass**
die Abschirmung (4) an mindestens einer Stelle mit einer Unterbrechung (2) versehen wird und diese mit einem verlustbehafteten oder verlustfreien Zweipol (5) überbrückt wird, sodass dadurch im Vergleich zu einem Zustand ohne die Unterbrechung in der Abschirmung (4) auftretende parasitären Ströme effektiv reduziert werden.

## Claims

1. Symmetrical screened cable (1) for electrically linking electronic assemblies, components (10) or peripheral units, comprising two inner conductors (6) for at least one usage signal and at least one screening (4), wherein both inner conductors (6) are shielded by means of the screening (4) against effects of an alternating electromagnetic field,
**characterised in that**
the screening (4) has an interruption (2) at at least one point, which interruption is bridged by a lossy or lossless two-pole (5), so that by this in comparison to a condition without the interruption in the screening (4) occurring parasitic currents are effectively reduced.

2. Symmetrical screened cable (1) according to claim 1,
**characterised in that**
the symmetrical screened cable (1) is suitable for electrically linking a component, which is a part or a peripheral unit of an MRI or NMR machine.

3. Symmetrical screened cable (1) according to claim 2,
**characterised in that**
the MRI or NMR machine is suitable for generating magnetic fields which are stronger than 0.1 T, preferably stronger than 3 T, more preferably 7 T or stronger.

4. Symmetrical screened cable (1) according to either claim 2 or claim 3,
**characterised in that**
the component, the part or the peripheral unit of the MRI or NMR machine is selected from a group including an HF coil and/or HF antenna, a coil and/or antenna array, control electronics, a communications system, a camera, a motion sensor, a video and/or image display device, a loudspeaker, a microphone, a detection means for physiological signals, preferably a heat sensor, a blood pressure sensor, a position sensor and/or a heart rate monitor.

5. HF coil and/or HF antenna and/or a coil and/or antenna array, electrically connected by means of the symmetrical screened cable (1) according to any of the preceding claims.

6. Symmetrical screened cable (1) according to any of the claims 1-4,
**characterised in that**
the symmetrical screened cable (1) is a twinaxial cable or a grouping of several coaxial cables.

7. Symmetrical screened cable (1) according to any of the claims 1-4 and 6,

**characterised in that**
the lossy two-pole (5) bridging the interruption (2) is selected from a group comprising a passive, linear two-pole, preferably an ohmic resistor, reactance, inductance L, and/or capacitor, a non-linear two-pole, a two-pole which can be switched by means of a controlled variable and a two-pole which can be changed continuously by means of a controlled variable, preferably a PIN diode, a varactor diode or a variable capacitor.

8. Symmetrical screened cable (1) according to any of the claims 1 - 4, 6 and 7,
**characterised in that**
the device further comprises at least one balun.

9. Symmetrical screened cable (1) according to any of the claims 1-4 and 6-8,
**characterised in that**
the device comprises at least one additional envelope wave blocker.

10. Symmetrical screened cable (1) according to any of the claims 1-4 and 6-9,
**characterised in that**
the interruption (2) has a length of 0,001 - 50 mm, preferably of 0,01 - 10 mm and more preferably of 0,1 - 5 mm in the longitudinal direction of the symmetrical screened cable (1).

11. Symmetrical screened cable (1) according to any of the claims 1-4 and 6-10,
**characterised in that**
at least one interruption is arranged in the location where a maximum of the amplitude of the wave induced by the alternating electromagnetic field would form in the screening (4) of the symmetrical screened cable (1) in conjunction with the alternating electromagnetic field, if no interruption was present.

12. Use of the symmetrical screened cable (1) according to any of the claims 1-4 and 6 - 11, for electrically linking electronic assemblies, components (10) or peripheral units of an MRI or NMR machine.

13. Method for electrically linking electronic assemblies, components (10) or peripheral units by means of at least one symmetrical screened cable (1) which comprises two inner conductors (6) for at least one usage signal and a screening (4), wherein both inner conductors (6) are shielded by means of the screening (4) against effects of an alternating electromagnetic field,
**characterised in that**
the screening (4) is provided with an interruption (2) at at least one point, and said interruption is bridged by a lossy or lossless two-pole (5), so that by this in comparison to a condition without the interruption in the screening (4) occurring parasitic currents are effectively reduced.

## Revendications

1. Ligne blindée symétrique (1) pour la connexion électrique de modules, composants (10) ou unités périphériques électroniques, comportant deux conducteurs internes (6) pour au moins un signal utile et un blindage (4), les deux conducteurs internes (6) étant blindés contre des influences d'un champ électromagnétique alternatif au moyen du blindage (4),
**caractérisée par le fait que**
le blindage (4) présente en au moins une position une interruption (2) qui est pontée par un dipôle avec perte ou sans perte (5), de telle sorte que, de ce fait, par comparaison avec un état sans l'interruption dans le blindage (4), des courants parasites se produisant sont réduits de façon effective.

2. Ligne blindée symétrique (1) selon la revendication 1,
**caractérisée par le fait que**
la ligne blindée symétrique (1) est apte à la connexion électrique d'un composant, lequel est une partie ou une unité périphérique d'un appareil d'IRM ou de RMN.

3. Ligne blindée symétrique (1) selon la revendication 2,
**caractérisée par le fait que**
l'appareil d'IRM ou de RMN est apte à la génération de champs magnétiques plus forts que 0,1 T, de préférence plus forts que 3 T, de manière particulièrement préférée de 7 T ou plus.

**4.** Ligne blindée symétrique (1) selon l'une des revendications 2 ou 3,
**caractérisée par le fait que**
le composant, la partie ou l'unité périphérique de l'appareil d'IRM ou de RMN est choisi dans un groupe incluant une bobine RF et/ou une antenne RF, un réseau de bobines et/ou d'antennes, une électronique de commande, un dispositif de communication, une caméra, un détecteur de mouvement, une vidéo et/ou un dispositif d'affichage d'images, un haut-parleur, un microphone, un dispositif de détection pour des signaux physiologiques, de préférence un détecteur de chaleur, un capteur de pression sanguine, un capteur de position et/ou un moniteur cardiaque.

**5.** Bobine RF et/ou antenne RF et/ou réseau de bobines et/ou d'antennes, relié électriquement au moyen de la ligne blindée symétrique (1) selon l'une des revendications précédentes.

**6.** Ligne blindée symétrique (1) selon l'une des revendications 1 à 4,
**caractérisée par le fait que**
la ligne blindée symétrique (1) est un câble twinax ou une association de plusieurs câbles coaxiaux.

**7.** Ligne blindée symétrique (1) selon l'une des revendications 1 à 4 et 6,
**caractérisée par le fait que**
le dipôle avec perte (5) pontant l'interruption (2) est choisi dans un groupe qui comporte un dipôle linéaire passif, de préférence une résistance ohmique, une réactance, une inductance L et/ou un condensateur, un dipôle non linéaire, un dipôle commutable au moyen d'une grandeur de réglage et un dipôle modifiable de façon continue au moyen d'une grandeur de réglage, de préférence une diode PIN, une diode capacitive ou un condensateur rotatif.

**8.** Ligne blindée symétrique (1) selon l'une des revendications 1 à 4, 6 et 7,
**caractérisée par le fait que**
le dispositif comporte en outre au moins un symétriseur.

**9.** Ligne blindée symétrique (1) selon l'une des revendications 1 à 4 et 6 à 8,
**caractérisée par le fait que**
le dispositif présente au moins une autre barrière contre les ondes de gaine.

**10.** Ligne blindée symétrique (1) selon l'une des revendications 1 à 4 et 6 à 9,
**caractérisée par le fait que**
l'interruption (2) présente une longueur de 0,001-50 mm, de préférence de 0,01-10 mm et de façon particulièrement préférée de 0,1-5 mm dans la direction longitudinale de la ligne blindée symétrique (1).

**11.** Ligne blindée symétrique (1) selon l'une des revendications 1 à 4 et 6 à 10,
**caractérisée par le fait qu'**
au moins une interruption est disposée là où un maximum de l'amplitude de l'onde induite par le champ électromagnétique alternatif se formerait dans le blindage (4) de la ligne blindée symétrique (1) en interaction avec le champ électromagnétique alternatif s'il n'y avait pas d'interruption.

**12.** Utilisation de la ligne blindée symétrique (1) selon l'une des revendications 1 à 4 et 6 à 11, pour la connexion électrique de modules, composants (10) ou unités périphériques électroniques d'un appareil d'IRM ou de RMN.

**13.** Procédé de connexion électrique de modules, composants (10) ou unités périphériques électroniques au moyen d'au moins une ligne blindée symétrique (1), qui comporte deux conducteurs internes (6) pour au moins un signal utile et un blindage (4), les deux conducteurs internes (6) étant blindés contre des influences d'un champ électromagnétique alternatif au moyen du blindage (4),
**caractérisé par le fait que**
le blindage (4) est pourvu d'une interruption (2) en au moins une position et celle-ci est pontée par un dipôle avec perte ou sans perte (5), de telle sorte que, de ce fait, par comparaison avec un état sans l'interruption dans le blindage (4), des courants parasites se produisant sont réduits de façon effective.

Fig. 1a

Fig. 1b

Fig. 1c

Fig. 1d

Fig. 1e

Fig. 2

Fig. 3a

Fig. 3b

Fig. 3c

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 6982378 B2
- US 2011243255 A1
- DE 602004007641 T2
- US 2010329527 A1
- WO 2011051872 A2
- US 2011037471 A1

### In der Beschreibung aufgeführte Nicht-Patentliteratur

- **ROEMER, P. B. et al.** The NMR phased array. *Magnetic Resonance in Medicine,* 1990, vol. 16, 192-225
- **VAUGHAN, J. T. et al.** RF Coils for MRI. Wiley, 2012
- **ACKERMAN, J. J. H. et al.** Mapping of metabolites in whole animals by P NMR using surface coils. *Nature,* 1980, vol. 283, 167-170
- **HAYES, C. E. et al.** An efficient, highly homogeneous radiofrequency coil for whole-body NMR imaging at 1.5 T. *Journal of Magnetic Resonance,* 1985, vol. 63, 622-628
- **R. F. LEE, R. F. et al.** Planar strip array (PSA) for MRI. *Magnetic Resonance in Medicine,* 2001, vol. 45, 673-683
- **DRIESEL, W. et al.** A microstrip helmet coil for human brain imaging at high magnetic field. *Concepts in Magnetic Resonance Part B (Magnetic Resonance Engineering),* 2008, vol. 33B, 94-108
- **RAAIJMAKERS, A. J. E. et al.** Design of a radiative surface coil array element at 7 T: The single-side adapted dipole antenna. *Magnetic Resonance in Medicine,* 2011, vol. 66, 1488-1497
- **BRUNNER, D. O. et al.** Travelling wave nuclear magnetic resonance. *Nature,* 2009, vol. 457, 994-999
- **PICARD, L. et al.** Improvements in electronic decoupling of transmitter and receiver coils. *Journal of Magnetic Resonance,* 1995, vol. 106, 110-115
- **TERMAN, F. E.** Radio Engineering. McGraw-Hill, 1937, 76-85
- **MISPELTER, J. et al.** NMR Probeheads for Biophysical and Biomedical Experiments. Imperial College Press, 2006
- **VON BOSKAMP, E. B. et al.** Broadband damping of cable modes. *Proceedings of the 20th Annual Meeting of ISMRM, Melbourne,* 2012, vol. 2691